# EUROPEAN PATENT APPLICATION

(11) **EP 4 683 460 A2**
(43) Date of publication of application: **21.01.2026**
(21) Application number: 25209651.6
(22) Date of filing: 20.10.2025
(51) Int. Cl.: H10F 10/14, H10F 71/00, H10F 77/20, H10F 77/30, H10F 77/70

(54) **SOLAR CELL AND PREPARATION METHOD THEREOF**

(30) Priority: 09.01.2025 CN 202510038508
(71) Applicant: Jinko Solar (Shangrao) Co., Ltd., Shangrao, Jiangxi 334100 (CN); Zhejiang Jinko Solar Co., Ltd., Haining, Zhejiang 314416 (CN)
(72) Inventor: FANG, Lingxin, Shangrao, Jiangxi, 334100 (CN); ZHANG, Yuanfang, Shangrao, Jiangxi, 334100 (CN); WANG, Zhao, Shangrao, Jiangxi, 334100 (CN); ZHENG, Peiting, Shangrao, Jiangxi, 334100 (CN); YANG, Jie, Shangrao, Jiangxi, 334100 (CN); ZHANG, Xinyu, Shangrao, Jiangxi, 334100 (CN); LV, Yanfeng, Shangrao, Jiangxi, 334100 (CN); GU, Wenxian, Shangrao, Jiangxi, 334100 (CN)
(74) Representative: Ipsilon

(57) **Abstract**

A solar cell includes a semiconductor substrate including a main light receiving surface and a back surface arranged opposite thereto; a light trapping microstructure arranged on the main light receiving surface, the light trapping microstructure including a plurality of pyramid microstructures; a doped conductive layer located in an upper region of at least part of the pyramid microstructures and spaced apart from a bottom surface of at least part of the pyramid microstructures; a passivation layer located on a surface of the light trapping microstructure; a first electrode, the first electrode at least partially extending through the passivation layer and being in ohmic contact with the doped conductive layer; a back passivation contact structure located on the back surface; and a second electrode, the second electrode being in ohmic contact with the back passivation contact structure.

## Description

### TECHNICAL FIELD

The present invention relates to the field of solar cell technologies, and in particular, to a solar cell and a preparing method thereof.

### BACKGROUND

Boron diffusion layer of an existing Tunnel Oxide Passivated Contact (TOPCon) solar cell has a full-surface boron diffusion structure, and a grid-line region and a non-grid-line region each have a boron diffusion layer.

Even if a boron diffusion region in the non-grid-line region is removed by laser, excess boron diffusion regions may still exist in the grid-line region, which may still affect passivation of a silicon substrate. At the same time, during formation of metal grid lines, contact between paste and the boron diffusion region may be relatively large, leading to increased metal recombination. As a result, performance of the solar cell is affected.

### SUMMARY

Accordingly, it is necessary to provide a solar cell and a preparing method thereof.

In a first aspect of the present invention, a solar cell is provided, including: a semiconductor substrate including a main light receiving surface and a back surface that are oppositely arranged; a light trapping microstructure arranged on the main light receiving surface, the light trapping microstructure including a plurality of pyramid microstructures; a doped conductive layer located in an upper region of at least part of the pyramid microstructures and spaced apart from a bottom surface of at least part of the pyramid microstructures; a passivation layer located on the light trapping microstructure; a first electrode, the first electrode at least partially extending through the passivation layer and being in ohmic contact with the doped conductive layer; a back passivation contact structure located on the back surface; and a second electrode in ohmic contact with the back passivation contact structure.

In some embodiments, in a thickness direction of the semiconductor substrate, a thickness of the doped conductive layer is less than a height of the pyramid microstructure.

In some embodiments, a thickness of the doped conductive layer ranging from 0.2 µm to 1 µm.

In some embodiments, a ratio of a thickness of the doped conductive layer to a height of the pyramid microstructure is less than 80%.

In some embodiments, a height of the pyramid microstructure ranges from 0.3 µm to 2.5 µm.

In some embodiments, in a thickness direction of the semiconductor substrate, a cross section of the pyramid microstructure is trapezoidal, trapezoid-like, triangular, or triangle-like.

In some embodiments, the solar cell further includes an anti-reflection layer, the anti-reflection layer is located on the passivation layer; and at least part of the first electrode extending through the anti-reflection layer.

In some embodiments, the solar cell further includes a textured structure formed on the main light receiving surface, and the light trapping microstructure is formed on the textured structure.

In some embodiments, a conductivity type of the doped conductive layer is opposite to a conductivity type of the semiconductor substrate.

In some embodiments, the passivation layer has a multi-layer structure constituted of a silicon nitride layer and an aluminum oxide layer.

In some embodiments, the back passivation contact structure includes a tunneling layer, a doped polysilicon layer, and an anti-reflection film layer that are stacked on the semiconductor substrate sequentially.

In some embodiments, a conductivity type of a doping element of the doped polysilicon layer is opposite to a conductivity type of the semiconductor substrate.

In some embodiments, a conductivity type of the doping element of the doped polysilicon layer is the same as a conductivity type of the semiconductor substrate, and a doping concentration of the doped polysilicon layer is greater than a doping concentration of the semiconductor substrate.

In some embodiments, the anti-reflection film layer has a multi-layer structure constituted of a silicon nitride layer and an aluminum oxide layer.

In a second aspect of the present invention, a method for preparing a solar cell is provided, the method includes: providing the semiconductor substrate; forming a doped diffusion layer on the main light receiving surface by a diffusion process; removing a first region of the doped diffusion layer and performing texturing on a remaining second region to form a light trapping microstructure, and obtaining the pyramid microstructure having a doped conductive layer in an upper region thereof; forming the passivation layer on the light trapping microstructure; and forming the first electrode.

In some embodiments, a textured structure is formed on the main light receiving surface.

In some embodiments, removing the first region of the doped diffusion layer and texturing the remaining second region to form the light trapping microstructure, and obtaining the pyramid microstructure having the doped conductive layer in the upper region includes: removing the first region of the doped diffusion layer, and retaining the second region of the doped diffusion layer; and performing texturing on the second region to form a plurality of pyramid microstructures having heights greater than a thickness of the doped diffusion layer.

In some embodiments, the removing the first region of the doped diffusion layer and texturing the remaining second region to form the light trapping microstructure, and obtaining the pyramid microstructure having the doped conductive layer in the upper region includes: activating the first region by a first laser, and activating the second region by a second laser, wherein a spot diameter of the first laser is greater than a side length of a base of the pyramid microstructure, and a spot diameter of the second laser is no greater than the side length of the base of the pyramid microstructure; and performing texturing, removing the first region, and forming a plurality of pyramid microstructures in the second region.

In some embodiments, a side length of the pyramid microstructure ranges from 0.3 µm to 1 µm, and the spot diameter of the first laser ranges from 100 µm to 400 µm; and the spot diameter of the second laser ranges from 0.3 µm to 1 µm.

In some embodiments, prior to forming the doped diffusion layer on the main light receiving surface by the diffusion process, the method further includes: texturing and/or polishing the main light receiving surface of the semiconductor substrate.

According to the aforementioned solar cell, the doped conductive layer is only located at the top of the pyramid microstructure and only exists on the top of the pyramid microstructure in a region where the light trapping microstructure is located. There is no redundant doped diffusion layer on the surface of the semiconductor substrate, so that the metal recombination and Auger recombination are minimized, resulting in a small passivation effect on the surface of the semiconductor substrate. The first electrode is in contact with the doped conductive layer only at the top of the pyramid microstructure, which reduces a contact area between the first electrode and the doped conductive layer but does not reduce an effective contact area, thereby reducing metal recombination and effectively increasing an open-circuit voltage, a fill factor, and conversion efficiency.

### BRIEF DESCRIPTION OF THE DRAWINGS

FIG. 1 is a schematic structural view of a solar cell according to an embodiment of the present invention;
FIG. 2 is a schematic flowchart of a preparing method for a solar cell according to an embodiment of the present invention;
FIG. 3 is a schematic structural view after step S100 of the preparing method according to the present invention;
FIG. 4 is a schematic structural view after step S200 of the preparing method according to the present invention;
FIG. 5 is a schematic structural view after step S300 of the preparing method according to the present invention;
FIG. 6 is a schematic structural view after step S400 of the preparing method according to the present invention;
FIG. 7 is a schematic flowchart of a first implementation of step S300 according to embodiments of the present invention;
FIG. 8 is a schematic view of implementation of step S310 according to embodiments of the present invention;
FIG. 9 is a schematic flowchart of a second implementation of step S300 according to embodiments of the present invention; and
FIG. 10 is a schematic view of implementation of step S310' according to embodiments of the present invention.

### DETAILED DESCRIPTION

In order to make the above objectives, features, and advantages of the present invention more obvious and understandable, specific implementations of the present invention are described in detail below with reference to the accompanying drawings. In the following description, many specific details are set forth in order to fully understand the present invention. However, the present invention can be implemented in many other ways different from those described herein, and those skilled in the art can make similar improvements without departing from the connotation of the present invention. Therefore, the present invention is not limited by specific embodiments disclosed below.

In the description of the present invention, it should be understood that the orientation or position relationships indicated by the terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present invention and simplify the description only, rather than indicating or implying that the apparatus or element referred to must have a particular orientation or be constructed and operated in a particular orientation, and therefore are not to be interpreted as limiting the present invention.

In addition, the terms "first" and "second" are used for descriptive purposes only, which cannot be construed as indicating or implying a relative importance, or implicitly specifying the number of the indicated technical features. Therefore, the features defined with "first" and "second" may explicitly or implicitly include at least one feature. In the description of the present invention, if the term "a plurality of" appears, "a plurality of" means at least two, such as two or three, unless otherwise defined explicitly and specifically.

In the present invention, when a numerical interval (i.e., a numerical range) is mentioned, unless otherwise specified, distribution of suitable values in the numerical interval is considered as being continuous, and includes two numerical endpoints (i.e., minimum and maximum values) as well as every value between the two numerical endpoints. Unless otherwise specified, when the numerical interval refers to only integers in the numerical interval, two endpoint integers of the numerical interval and every integer between the two endpoint integers are included, which is equivalent to directly enumerating each integer. When multiple numerical ranges are provided to describe a specific feature or characteristic, these numerical ranges may be combined. In other words, unless otherwise indicated, the numerical ranges in the present invention should be understood to encompass any and all subranges included therein. The "values" in the numerical interval may be any quantitative values, such as numbers, percentages, or ratios. The term "numerical interval" allows broadly including quantitative intervals such as percentage intervals, proportion intervals, and ratio intervals.

Unless otherwise indicated in the context, the materials described herein may be formed by any appropriate technology. The technology includes, but is not limited to, spin coating, blanket coating, chemical vapor deposition (CVD), plasma enhanced CVD (PECVD), atomic layer deposition (ALD), plasma enhanced ALD (PEALD), physical vapor deposition (PVD) (e.g., sputtering), or epitaxial growth. Depending on the specific material to be formed, the technology for depositing or growing the material may be selected by those of ordinary skill in the art.

In addition, unless otherwise indicated in the context, the removal of the materials described herein may be accomplished by any suitable technology. The technology includes, but is not limited to, etching (e.g., dry etching, wet etching, vapor etching), ion milling, abrasive planarization (e.g., chemical-mechanical planarization (CMP)), or other known methods.

The term "semiconductor" used herein may refer to, for example, a material layer, a wafer, or a substrate, and includes any base semiconductor structure. "Semiconductor" should be understood as including a silicon-on-sapphire (SOS) technology, a silicon-on-insulator (SOI) technology, a thin film transistor (TFT) technology, doped and undoped semiconductors, an epitaxial silicon layer supported by a base semiconductor structure, as well as other semiconductor structures well known to those skilled in the art.

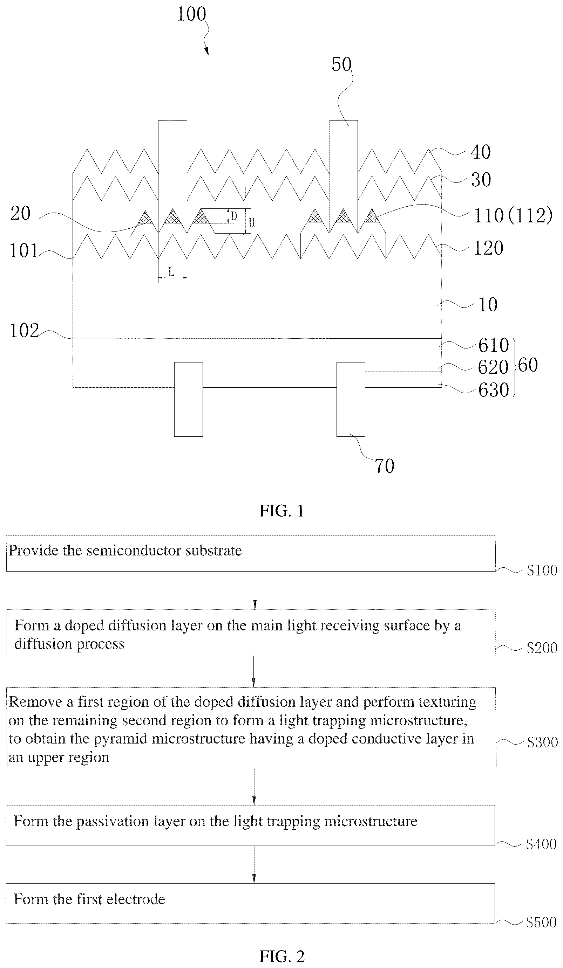

In a first aspect, referring to FIG. 1, embodiments of the present invention provide a solar cell 100. The solar cell 100 includes a semiconductor substrate 10, a light trapping microstructure 110, a doped conductive layer 20, a passivation layer 30, an anti-reflection layer 40, a first electrode 50, a back passivation contact structure 60, and a second electrode 70.

The semiconductor substrate 10 includes a main light receiving surface 101 and a back surface 102 that are oppositely arranged. The light trapping microstructure 110 is arranged on the main light receiving surface 101. The light trapping microstructure 110 includes a plurality of pyramid microstructures 112. The doped conductive layer 20 is located in an upper region of at least part of the pyramid microstructures 112 and spaced apart from a bottom surface of at least part of the pyramid microstructures 112. The passivation layer 30 is located on a surface of the light trapping microstructure 110. The first electrode 50 at least partially extends through the passivation layer 30 and is in ohmic contact with the doped conductive layer 20. The back passivation contact structure 60 is located on the back surface 102. The second electrode 70 is in ohmic contact with the back passivation contact structure 60.

The main light receiving surface 101 of the semiconductor substrate 10 refers to a surface facing the sun when the solar cell 100 is in operation. The semiconductor substrate 10 is configured to receive incident light and generate photogenerated carriers. Optionally, the semiconductor substrate 10 may be, for example, silicon, germanium, germanium-silicon, or silicon on an insulator; and various doped silicon including, but not limited to, boron-doped, phosphorus-doped, gallium-doped, antimony-doped, or mixed doping.

The light trapping microstructure 110 may increase a light absorption area, increase a photogenerated current, and is conducive to improving efficiency of the solar cell 100. The pyramid microstructure 112 can reduce reflectivity of the main light receiving surface 101 and form a light trap to enhance an absorption effect of the semiconductor substrate 10 on incident light, thereby improving conversion efficiency of the solar cell 100.

Optionally, a textured structure 120 may further be formed on the main light receiving surface 101 of the semiconductor substrate 10. The light trapping microstructure 110 may be formed on the textured structure 120. The textured structure 120 may be, for example, a pyramid textured structure. In this case, a region on the main light receiving surface 101 of the semiconductor substrate 10 other than the light trapping microstructure 110 is the textured structure 120. Optionally, the region on the main light receiving surface 101 of the semiconductor substrate 10 other than the light trapping microstructure 110 may be a flat surface of the semiconductor substrate 10.

A conductivity type of the doped conductive layer 20 is opposite to a conductivity type of the semiconductor substrate 10. Optionally, the semiconductor substrate 10 is an N-type doped semiconductor. A doping element in the doped conductive layer 20 is a P-type doping element, such as boron.

The doped conductive layer 20 is specifically located in an upper region of the pyramid microstructure 112 and is spaced apart from a bottom surface of the pyramid microstructure 112. That is, the doped conductive layer 20 is only located at the top of the pyramid microstructure 112 of the light trapping microstructure 110. For example, the top of each pyramid microstructure 112 in the light trapping microstructure 110 may be provided with the doped conductive layer 20; alternatively, the top of part of the pyramid microstructures 112 of the light trapping microstructure 110 may be provided with the doped conductive layer 20.

The passivation layer 30 is located on the surface of the light trapping microstructure 110, thus ensuring that the semiconductor substrate 10 has a good passivation effect at the main light receiving surface 101. The passivation layer 30 may be made of, for example, one of silicon oxide, aluminum oxide, silicon nitride, and silicon oxynitride. The passivation layer 30 may have a single-layer structure or a multi-layer structure. For the multi-layer structure, materials in different layers may be different from each other, or materials in a certain number of layers may be the same and be different from materials in other layers. For example, the passivation layer 30 may have a multi-layer structure constituted of a silicon nitride layer and an aluminum oxide layer.

The solar cell 100 further includes an anti-reflection layer 40, and the anti-reflection layer 40 is located on the passivation layer 30. At least part of the first electrode 50 extends through the anti-reflection layer 40. The anti-reflection layer 40 can reduce optical reflection loss on a surface of the solar cell 100 and improve light absorption efficiency of the solar cell 100. The anti-reflection layer 40 may be made of, for example, one of silicon oxide, aluminum oxide, silicon nitride, and silicon oxynitride. The anti-reflection layer 40 may have a single-layer structure or a multi-layer structure. For the multi-layer structure, materials in different layers may be different from each other, or materials in a certain number of layers may be the same and different from materials in other layers. For example, the anti-reflection layer 40 may have a multi-layer structure constituted of a silicon nitride layer and an aluminum oxide layer.

The first electrode 50 is in ohmic contact with the doped conductive layer 20, so as to collect and transfer charges in the semiconductor substrate 10. The first electrode 50 includes various metal grid lines, which may be made of, but not limited to, silver, copper, tin, or mixed metal. More than two first electrodes 50 may be provided. Each first electrode 50 is in ohmic contact with the doped conductive layer 20 in at least one pyramid microstructure 112.

The back passivation contact structure 60 is provided on the back surface 102 of the semiconductor substrate 10. The second electrode 70 is in contact with the back passivation contact structure 60 to collect and transfer charges. More than two second electrodes 70 may be provided. Each second electrode 70 is in ohmic contact with the back passivation contact structure 60.

In the present invention, the back passivation contact structure 60 isolates the second electrode 70 from the semiconductor on the surface of the semiconductor substrate 10 while realizing carrier tunneling, thereby effectively reducing recombination loss caused by direct contact between a metal electrode and a silicon wafer, and achieving "passivation" and "contact" effects at the same time.

Optionally, the back passivation contact structure 60 includes a tunneling layer 610, a doped polysilicon layer 620, and an anti-reflection film layer 630 that are stacked on the back surface 102 of the semiconductor substrate 10 sequentially. The tunneling layer 610 is located on the semiconductor substrate 10, which can reduce interface-state density between the semiconductor substrate 10 and the doped polysilicon layer 620, reduce a probability of carrier recombination, and improve efficiency of the solar cell 100. In an example, the tunneling layer 610 is made of silicon oxide. The doped polysilicon layer 620 is in ohmic contact with the second electrode 70, which further passivates the surface of the semiconductor substrate 10 and provides a low-resistance charge collection and transferring path. Optionally, a conductivity type of a doping element of the doped polysilicon layer 620 is opposite to a conductivity type of the semiconductor substrate 10. Alternatively, the conductivity type of the doping element of the doped polysilicon layer 620 is the same as the conductivity type of the semiconductor substrate 10, but a doping concentration of the doped polysilicon layer 620 is greater than a doping concentration of the semiconductor substrate 10.

The anti-reflection film layer 630 can reduce optical reflection loss on the surface of the solar cell 100 and improve light absorption efficiency of the solar cell 100. The anti-reflection film layer 630 may be made of, for example, one of silicon oxide, aluminum oxide, silicon nitride, and silicon oxynitride. The anti-reflection film layer 630 may have a single-layer structure or a multi-layer structure. For the multi-layer structure, materials in different layers may be different from each other, or materials in a certain number of layers may be the same and different from materials in other layers. For example, the anti-reflection film layer 630 may have a multi-layer structure constituted of a silicon nitride layer and an aluminum oxide layer.

In the present invention, the doped conductive layer 20 is only located at the top of the pyramid microstructure 112 and only exists on the top of the pyramid microstructure 112 in a region where the light trapping microstructure 110 is located. There is no redundant doped diffusion layer 80 on the surface of the semiconductor substrate 10, so that the metal recombination and Auger recombination are minimized, resulting in a small passivation effect on the surface of the semiconductor substrate 10. The first electrode 50 is in contact with the doped conductive layer 20 only at the top of the pyramid microstructure 112, which reduces a contact area between the first electrode 50 and the doped conductive layer 20 but does not reduce an effective contact area, thereby reducing metal recombination and effectively increasing an open-circuit voltage, a fill factor, and conversion efficiency.

In some embodiments, in a thickness direction of the semiconductor substrate 10, a thickness of the doped conductive layer 20 is less than a height of the pyramid microstructure 112. For example, the thickness of the doped conductive layer 20 ranges from 0.2 µm to 1 µm. As shown in FIG. 1, the thickness direction of the semiconductor substrate 10 is a vertical direction.

The doped conductive layer 20 and the semiconductor substrate 10 form a "PN junction". The thickness D of the doped conductive layer 20 may be interpreted as a junction depth of the "PN junction". In the present invention, the doped conductive layer 20 is located adjacent to the top of the pyramid microstructure 112, and the junction depth of the "PN junction" is less than a height H of the pyramid microstructure 112.

The thickness of the doped conductive layer 20 ranges from 0.2 µm to 1 µm. Optionally, the thickness of the doped conductive layer 20 is 0.2 µm; 0.25 µm; 0.3 µm; 0.33 µm; 0.35 µm; 0.38 µm; 0.4 µm; 0.42 µm; 0.46 µm; 0.5 µm; 0.55 µm; 0.58 µm; 0.61 µm; 0.64 µm; 0.68 µm; 0.7 µm; 0.75 µm; 0.8 µm; 0.85 µm; 0.9 µm; 0.96 µm; or 1 µm.

In some embodiments, a ratio of the thickness D of the doped conductive layer 20 to the height H of the pyramid microstructure 112 is less than 80%. The ratio of the thickness D of the doped conductive layer 20 to the height H of the pyramid microstructure 112 is controlled to be less than 80%, which reduces the contact area between the first electrode 50 and the doped conductive layer 20 but does not reduce the effective contact area, thereby reducing metal recombination and effectively increasing the open-circuit voltage, the fill factor, and the conversion efficiency.

Optionally, the height of the pyramid microstructure 112 ranges from 0.3 µm to 2.5 µm. For example, the height H of the pyramid microstructure 112 is 0.3 µm; 0.5 µm; 0.9 µm; 1 µm; 1.2 µm; 1.6 µm; 1.8 µm; 2 µm; 2.25 µm; or 2.5 µm.

In some embodiments, in the thickness direction of the semiconductor substrate 10, a cross section of the pyramid microstructure 112 is trapezoidal, trapezoid-like, triangular, or triangle-like. In a direction away from the main light receiving surface 101, a width of the cross section of the pyramid microstructure 112 gradually decreases, and the specific shape of the cross section of the pyramid microstructure 112 may be any one of a trapezoid, a trapezoid-like shape, a triangle, or a triangle-like shape.

The above structure can reduce reflectivity of the main light receiving surface 101 and form a light trap to enhance an absorption effect of the semiconductor substrate 10 on incident light, thereby improving conversion efficiency of the solar cell 100.

In a second aspect, referring to FIG. 2, embodiments of the present invention provide a method for preparing a solar cell 100. The method may be used to manufacture the solar cell 100 in the first aspect. Specifically, the preparing method includes the following steps.

In S100, the semiconductor substrate 10 is provided.

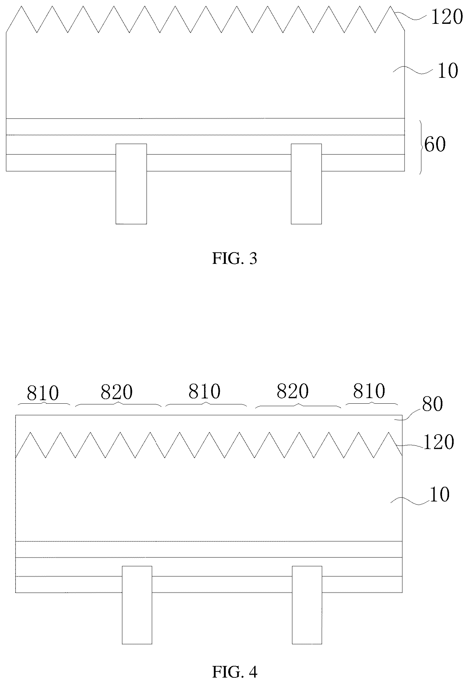

As shown in FIG. 3, in this step, the semiconductor substrate 10 is provided. Both side surfaces of the semiconductor substrate 10 may be polished and then cleaned. Optionally, the semiconductor substrate 10 is an N-type semiconductor. A textured structure 120 may also be formed on the main light receiving surface 101.

In addition, it may be understood that the back surface 102 of the semiconductor substrate 10 in the embodiments of the present invention may be provided with all layers that have been manufactured, and a specific structure thereof is not limited. Therefore, only the corresponding structure is manufactured on the main light receiving surface 101 in the embodiments of the present invention.

In S200, a doped diffusion layer 80 is formed on the main light receiving surface 101 by a diffusion process.

As shown in FIG. 4, optionally, a boron-doped diffusion layer having a thickness of 0.2 µm to 1 µm may be formed in a diffusion furnace. The boron-doped diffusion layer covers the entire main light receiving surface 101.

In S300, a first region 810 of the doped diffusion layer 80 is removed and texturing is performed on a remaining second region 820 of the doped diffusion layer 80 to form a light trapping microstructure 110, thus obtaining the pyramid microstructure 112 having a doped conductive layer 20 in an upper region.

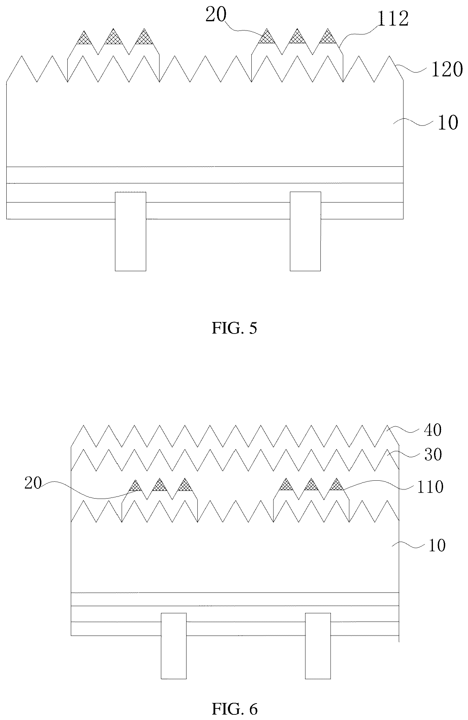

Referring to FIG. 4, the second region 820 is a region where the first electrode 50 is to be arranged, which is an electrode boron diffusion region. The first region 810 is a non-electrode boron diffusion region. Referring to FIG. 5, in this step, the doped diffusion layer 80 in the non-electrode boron diffusion region is removed to expose the main light receiving surface 101, and a light trapping microstructure 110 including a plurality of pyramid microstructures 112 is formed in the electrode boron diffusion region. Moreover, in the electrode boron diffusion region, the doped diffusion layer 80 is only retained at the top of the pyramid microstructure 112, so as to form the doped conductive layer 20 of the present invention.

It is to be noted that, in this step, a height H of the formed pyramid microstructure 112 should satisfy the following requirement: a specific thickness D of the doped boron diffusion layer is less than 80% of the height H of the pyramid microstructure 112.

In S400, the passivation layer 30 is formed on the light trapping microstructure 110. For example, the passivation layer 30 made of silicon nitride is manufactured by low pressure chemical vapor deposition (LPCVD) or plasma enhanced chemical vapor deposition (PECVD), as shown in FIG. 6.

In S500, the first electrode 50 is formed. For example, the first electrode 50 is manufactured by LPCVD or PECVD, thus obtaining the structure as shown in FIG. 1. Specifically, contact metallization may be formed only at the top of the pyramid microstructure 112 by laser enhanced auxiliary contact after printing with low fire-through paste.

According to the preparing method in the present invention, in the obtained solar cell 100, only the region where the first electrode 50 is arranged is provided with the doped diffusion layer 80, the doped diffusion layer 80 is located at the top of the pyramid microstructure 112 to form the doped conductive layer 20 of the present invention, and there is no redundant doped diffusion layer 80 on the surface of the semiconductor substrate 10, such that metal recombination and Auger recombination are minimized, resulting in a small passivation effect on the surface of the semiconductor substrate 10. The first electrode 50 is in contact with the doped conductive layer 20 only at the top of the pyramid microstructure 112, which reduces a contact area between the first electrode 50 and the doped conductive layer 20 but does not reduce an effective contact area, thereby reducing metal recombination and effectively increasing an open-circuit voltage, a fill factor, and conversion efficiency.

In the present invention, step S300 may be achieved through some different embodiments.

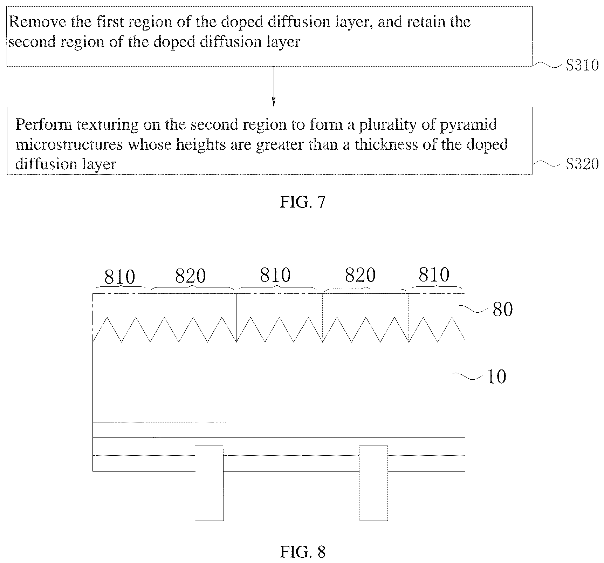

As shown in FIG. 7 and FIG. 8, a first embodiment of step S300 includes the following steps.

In S310, the first region 810 of the doped diffusion layer 80 is removed, and the second region 820 of the doped diffusion layer 80 is retained.

Prior to this step, the formed doped diffusion layer 80 has been subjected to drive-in oxidation. In this step, the first region 810 of the doped diffusion layer 80 may be etched away by laser, leaving only the second region 820 of the doped diffusion layer 80. After the first region 810 is removed, the main light receiving surface 101 of the semiconductor substrate 10 is exposed. In addition, in this step, after the first region 810 is removed, a natural oxide layer on the exposed part of the main light receiving surface 101 may be further removed by chain HF cleaning (hydrofluoric acid cleaning).

In S320, texturing is performed on the second region 820 to form a plurality of pyramid microstructures 112 having heights greater than a thickness of the doped diffusion layer 80.

Specifically, in this step, the semiconductor substrate 10 is placed in a texturing solution to etch the second region 820 of the doped diffusion layer 80. As shown in FIG. 5, the texturing solution enables the second region 820 to form a light trapping microstructure 110 having a plurality of pyramid microstructures 112. In the thickness direction of the semiconductor substrate 10, the cross section of the pyramid microstructure 112 is trapezoidal. The height H of the pyramid microstructure 112 ranges from 0.3 µm to 2.5 µm, which is greater than the thickness D of the doped conductive layer 20.

In this way, in the first embodiment of step S300, the first region 810 of the doped diffusion layer 80 is first removed, and then the light trapping microstructure 110 including the plurality of pyramid microstructures 112 is formed in the second region 820 by a texturing process. The doped diffusion layer 80 outside the light trapping microstructure 110 is etched away. The height H of the pyramid microstructure 112 is greater than the thickness D of the doped diffusion layer 80, so that only the upper region in the pyramid microstructure 112 is provided with the doped diffusion layer 80, and these doped diffusion layers 80 constitute the doped conductive layer 20 of the present invention.

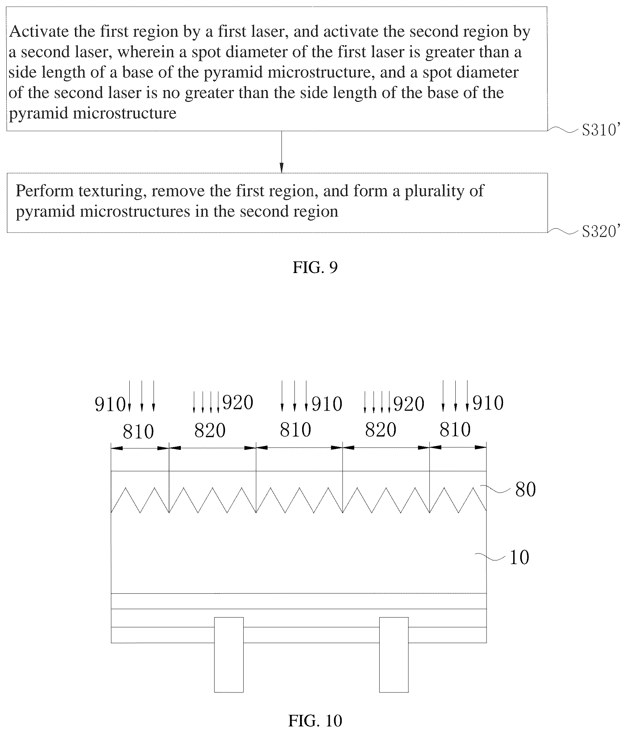

As shown in FIG. 9 and FIG. 10, a second embodiment of step S300 includes the following steps.

In S310', the first region 810 is activated by a first laser 200, and the second region 820 is activated by a second laser 300. A spot diameter of the first laser 200 is greater than a side length of a base of the pyramid microstructure 112, and a spot diameter of the second laser 300 is no greater than the side length of the base of the pyramid microstructure 112.

Specifically, prior to this step, the doped diffusion layer 80 is not subjected to drive-in oxidation, with a junction depth ranging from 0.2 µm to 1 µm. Activation is performed by using a laser selective emitter (SE). An activation region includes two regions, i.e., the first region 810 and the second region 820.

A laser spot with a larger diameter is used in the first region 810, so as to laser activate the boron-doped diffusion layer in this part, and the boron-doped diffusion layer can be completely etched away during subsequent texturing. A laser spot with a smaller diameter is used in the second region 820, and a moving speed of the laser spot is controlled, so that a region affected is subsequently textured to form the bottom of the undoped pyramid microstructure 112, and the upper region not affected is subsequently textured to form the top of the doped pyramid microstructure 112.

Optionally, the side length of the base of the pyramid microstructure 112 ranges from 0.3 µm to 1 µm. The spot diameter of the first laser 200 ranges from 100 µm to 400 µm. The spot diameter of the second laser 300 ranges from 0.3 µm to 1 µm. For example, the side length of the base of the pyramid microstructure 112 is 0.3 µm, the spot diameter of the first laser 200 is 100 µm, and the spot diameter of the second laser 300 is 0.3 µm. For example, the side length of the base of the pyramid microstructure 112 is 0.5 µm, the spot diameter of the first laser 200 is 200 µm, and the spot diameter of the second laser 300 is 0.4 µm. For example, the side length of the base of the pyramid microstructure 112 is 0.7 µm, the spot diameter of the first laser 200 is 300 µm, and the spot diameter of the second laser 300 is 0.6 µm. For example, the side length of the base of the pyramid microstructure 112 is 0.1 µm, the spot diameter of the first laser 200 is 400 µm, and the spot diameter of the second laser 300 is 1 µm.

In S320', texturing is performed to remove the first region, and a plurality of pyramid microstructures 112 are formed in the second region 820.

Specifically, in this step, the semiconductor substrate 10 is placed in a texturing solution to etch the second region 820 of the doped diffusion layer 80. As shown in FIG. 5, the texturing solution enables the second region 820 to form a light trapping microstructure 110 having a plurality of pyramid microstructures 112. In the thickness direction of the semiconductor substrate 10, the cross section of the pyramid microstructure 112 is trapezoidal. The height of the pyramid microstructure 112 ranges from 0.3 µm to 2.5 µm, which is greater than the thickness of the doped conductive layer 20.

In some embodiments, prior to step S200, the method further includes the following step.

In S60, the main light receiving surface 101 of the semiconductor substrate 10 is textured and/or polished. Defects and impurities on the surface of the semiconductor substrate 10 may be removed by polishing, thus improving smoothness and flatness.

In this step, a textured structure 120 may also be formed on the main light receiving surface 101 of the semiconductor substrate 10. In this way, the light trapping microstructure 110 can be formed on the textured structure 120. After the doped diffusion layer 80 of the first region 810 is removed, the exposed main light receiving surface 101 is the textured structure 120.

The solar cell 100 in the embodiments of the present invention are exemplarily described below with reference to some examples and related comparative examples.

During preparing of the solar cell 100 in the comparative examples, the main light receiving surface 101 is full-surface doped. A junction depth is 1.5±0.5 µm. A height of the pyramid microstructure is 1±0.5 µm. In Example 1 to Example 10, step S300 is implemented by the first implementation. Specifically,
Example 1: The ratio of the junction depth to the height of the pyramid microstructure 112 is 10%, the junction depth is 0.2 µm, and the height of the pyramid microstructure 112 is 2 µm.
Example 2: The ratio of the junction depth to the height of the pyramid microstructure 112 is 20%, the junction depth is 0.4 µm, and the height of the pyramid microstructure 112 is 2 µm.
Example 3: The ratio of the junction depth to the height of the pyramid microstructure 112 is 20%, the junction depth is 0.5 µm, and the height of the pyramid microstructure 112 is 2.5 µm.
Example 4: The ratio of the junction depth to the height of the pyramid microstructure 112 is 25%, the junction depth is 0.5 µm, and the height of the pyramid microstructure 112 is 2 µm.
Example 5: The ratio of the junction depth to the height of the pyramid microstructure 112 is 30%, the junction depth is 0.6 µm, and the height of the pyramid microstructure 112 is 2 µm.
Example 6: The ratio of the junction depth to the height of the pyramid microstructure 112 is 40%, the junction depth is 0.9 µm, and the height of the pyramid microstructure 112 is 2.25 µm.
Example 7: The ratio of the junction depth to the height of the pyramid microstructure 112 is 50%, the junction depth is 1 µm, and the height of the pyramid microstructure 112 is 2 µm.
Example 8: The ratio of the junction depth to the height of the pyramid microstructure 112 is 60%, the junction depth is 0.6 µm, and the height of the pyramid microstructure 112 is 1 µm.
Example 9: The ratio of the junction depth to the height of the pyramid microstructure 112 is 70%, the junction depth is 0.7 µm, and the height of the pyramid microstructure 112 is 1 µm.
Example 10: The ratio of the junction depth to the height of the pyramid microstructure 112 is 75%, the junction depth is 0.75 µm, and the height of the pyramid microstructure 112 is 1 µm.
In Example 11 to Example 16, step S300 is implemented by the second implementation. Specifically,
Example 11: The junction depth is 0.2 µm, the side length is 0.3 µm, the spot diameter of the first laser 200 acting on the first region 810 is 100 µm, and the spot diameter of the second laser 300 acting on the second region 820 is 0.3 µm.
Example 12: The junction depth is 0.4 µm, the side length is 0.4 µm, the spot diameter of the first laser 200 acting on the first region 810 is 200 µm, and the spot diameter of the second laser 300 acting on the second region 820 is 0.4 µm.
Example 13: The junction depth is 0.6 µm, the side length is 0.6 µm, the spot diameter of the first laser 200 acting on the first region 810 is 300 µm, and the spot diameter of the second laser 300 acting on the second region 820 is 0.5 µm.
Example 14: The junction depth is 0.8 µm, the side length is 0.8 µm, the spot diameter of the first laser 200 acting on the first region 810 is 300 µm, and the spot diameter of the second laser 300 acting on the second region 820 is 0.6 µm.
Example 15: The junction depth is 1 µm, the side length is 0.8 µm, the spot diameter of the first laser 200 acting on the first region 810 is 300 µm, and the spot diameter of the second laser 300 acting on the second region 820 is 0.8 µm.
Example 16: The junction depth is 1 µm, the side length is 1 µm, the spot diameter of the first laser 200 acting on the first region 810 is 400 µm, and the spot diameter of the second laser 300 acting on the second region 820 is 1 µm.

Experimental results are shown in the following table:

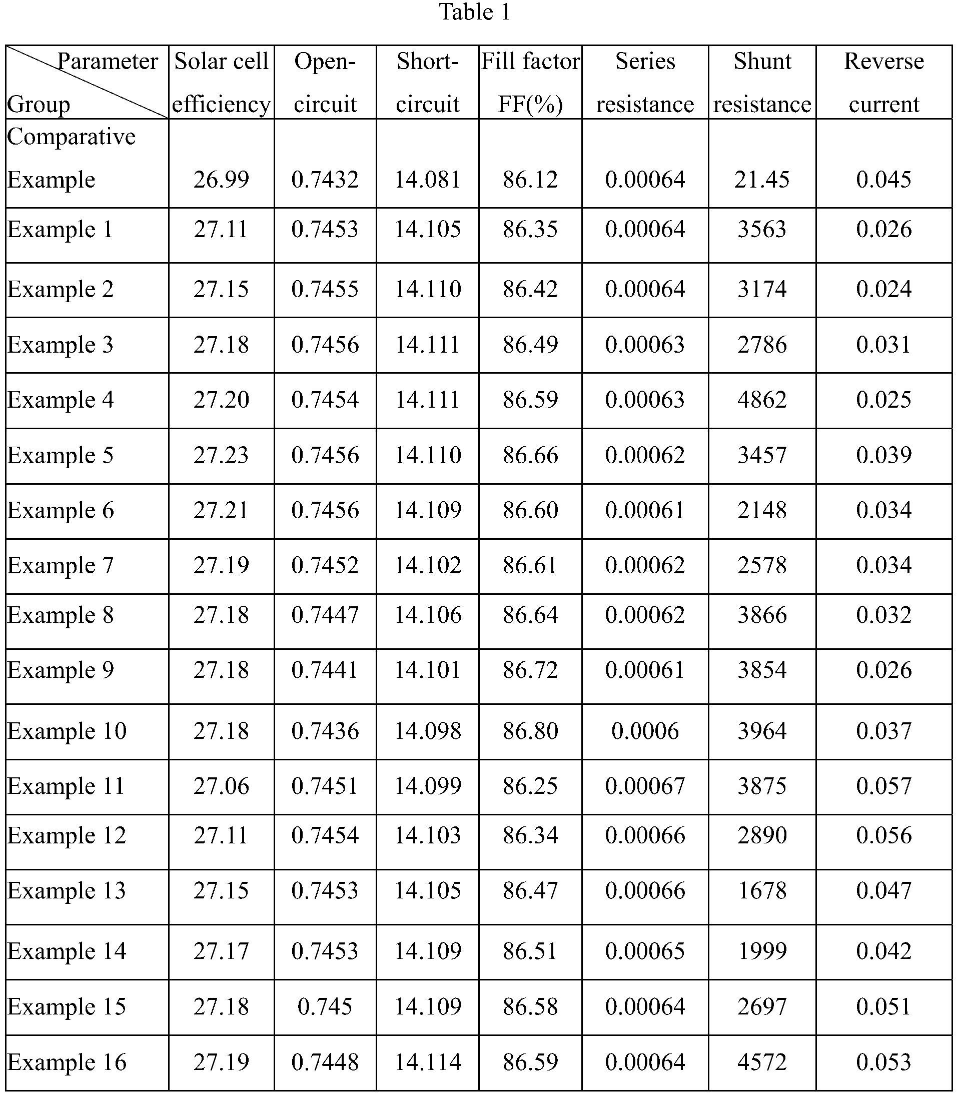

As can be seen, in Examples 1 to 16, by forming the doped conductive layer only at the top of the pyramid microstructure, metal recombination is reduced, thereby effectively increasing the open-circuit voltage, the fill factor, and the conversion efficiency.

## Claims

1. A solar cell, comprising:
a semiconductor substrate comprising a main light receiving surface and a back surface that are oppositely arranged;
a light trapping microstructure arranged on the main light receiving surface, the light trapping microstructure comprising a plurality of pyramid microstructures;
a doped conductive layer located in an upper region of at least part of the pyramid microstructures and spaced apart from a bottom surface of at least part of the pyramid microstructures;
a passivation layer located on the light trapping microstructure;
a first electrode at least partially extending through the passivation layer and in ohmic contact with the doped conductive layer;
a back passivation contact structure located on the back surface; and
a second electrode in ohmic contact with the back passivation contact structure.

2. The solar cell according to claim 1, wherein a thickness of the doped conductive layer is less than a height of the pyramid microstructure, and the thickness of the doped conductive layer ranges from 0.2 µm to 1 µm.

3. The solar cell according to claim 1 or 2, wherein a ratio of a thickness of the doped conductive layer to a height of the pyramid microstructure is less than 80%.

4. The solar cell according to any one of the preceding claims, wherein a cross section of the pyramid microstructure is trapezoidal, trapezoid-like, triangular, or triangle-like.

5. The solar cell according to any one of the preceding claims, further comprising an anti-reflection layer located on the passivation layer, and at least part of the first electrode extending through the anti-reflection layer.

6. The solar cell according to any one of the preceding claims, further comprising a textured structure formed on the main light receiving surface, and the light trapping microstructure being formed on the textured structure.

7. The solar cell according to any one of the preceding claims, wherein a conductivity type of the doped conductive layer is opposite to a conductivity type of the semiconductor substrate.

8. The solar cell according to any one of the preceding claims, wherein the back passivation contact structure comprises a tunneling layer, a doped polysilicon layer, and an anti-reflection film layer that are stacked on the semiconductor substrate sequentially.

9. The solar cell according to claim 8, wherein a conductivity type of a doping element of the doped polysilicon layer is opposite to a conductivity type of the semiconductor substrate.

10. The solar cell according to claim 8, wherein a conductivity type of the doping element of the doped polysilicon layer is the same as a conductivity type of the semiconductor substrate, and a doping concentration of the doped polysilicon layer is greater than a doping concentration of the semiconductor substrate.

11. A method for preparing the solar cell according to claim 1, comprising:
providing the semiconductor substrate;
forming a doped diffusion layer on the main light receiving surface by a diffusion process;
removing a first region of the doped diffusion layer and performing texturing on a remaining second region to form a light trapping microstructure, and obtaining the pyramid microstructure having a doped conductive layer in an upper region thereof;
forming the passivation layer on the light trapping microstructure; and
forming the first electrode.

12. The method according to claim 11, wherein removing the first region of the doped diffusion layer and texturing the remaining second region to form the light trapping microstructure, and obtaining the pyramid microstructure having the doped conductive layer in the upper region comprises:
removing the first region of the doped diffusion layer, and retaining the second region of the doped diffusion layer; and
performing texturing on the second region to form a plurality of pyramid microstructures having heights greater than a thickness of the doped diffusion layer.

13. The method according to claim 11 or 12, wherein the removing the first region of the doped diffusion layer and texturing the remaining second region to form the light trapping microstructure, and obtaining the pyramid microstructure having the doped conductive layer in the upper region comprises:
activating the first region by a first laser, and activating the second region by a second laser,
wherein a spot diameter of the first laser is greater than a side length of a base of the pyramid microstructure, and a spot diameter of the second laser is no greater than the side length of the base of the pyramid microstructure; and
performing texturing, removing the first region, and forming a plurality of pyramid microstructures in the second region.

14. The method according to claim 13, wherein a side length of the pyramid microstructure ranges from 0.3 µm to 1 µm, the spot diameter of the first laser ranges from 100 µm to 400 µm, and the spot diameter of the second laser ranges from 0.3 µm to 1 µm.

15. The method according to any one of claims 11 to 14, wherein prior to forming the doped diffusion layer on the main light receiving surface by the diffusion process, the method further comprises:
texturing and/or polishing the main light receiving surface of the semiconductor substrate.
